# EUROPEAN PATENT APPLICATION

(11) **EP 4 741 541 A2**
(43) Date of publication of application: **13.05.2026**
(21) Application number: 25212738.6
(22) Date of filing: 31.10.2025
(51) Int. Cl.: C30B 29/36, C30B 19/02, C30B 19/06, C30B 19/08

(54) **SIC SINGLE CRYSTAL SUBSTRATE, METHOD OF MANUFACTURING SIC SINGLE CRYSTAL, AND APPARATUS OF MANUFACTURING SIC SINGLE CRYSTAL**

(30) Priority: 11.11.2024 JP 2024196631; 24.07.2025 JP 2025123872
(71) Applicant: Proterial, Ltd., Tokyo 135-0061 (JP)
(72) Inventor: KUSUNOKI, Kazuhiko, Tokyo, 135-0061 (JP); HASEGAWA, Takashi, Tokyo, 135-0061 (JP); TAKAO, Kenta, Tokyo, 135-0061 (JP); ABE, Mai, Tokyo, 135-0061 (JP)
(74) Representative: Wilson Gunn

(57) **Abstract**

In an SiC single crystal substrate including a first main surface and a second main surface opposite to the first main surface, the SiC single crystal substrate in which the first main surface is a surface that tilts relative to a {0001} plane at an off-cut angle equal to or larger than 0° and equal to or smaller than 8° is used. In a distribution of phase differences obtained by measuring a phase difference between a first emission light and a second emission light emitted from the second main surface by making an incident light with two mutually perpendicular polarization components and a wavelength of 520 nm into the first main surface, an average value of the phase differences is equal to or smaller than 10 nm, and the maximum value of the phase differences is equal to or smaller than 70 nm.

## Description

### CROSS-REFERENCES TO RELATED APPLICATION

The disclosure of Japanese Patent Application No. 2024-196631 filed on November 11, 2024, and Japanese Patent Application No. 2025-123872 filed on July 24, 2025, including the specification, drawings and abstract is incorporated herein by reference in its entirety.

### TECHNICAL FIELD OF THE INVENTION

The present invention relates to a silicon carbide (SiC) single crystal substrate, a method of manufacturing SiC single crystal, and an apparatus of manufacturing SiC single crystal, and relates to, for example, a technique of manufacturing SiC single crystal by solution growth method.

### BACKGROUND OF THE INVENTION

The SiC single crystal has excellent physical properties to be very stable thermally and chemically, excellent in mechanical strength, resistant to radiation, and higher in breakdown voltage and heat conductivity than those of silicon (Si) single crystal. A semiconductor device using SiC single crystal can achieve high power, high frequency, high breakdown voltage, environmental tolerance, and the like, which cannot be achieved by a semiconductor device using an existing semiconductor material such as Si single crystal. Thus, SiC single crystal is awaited as a next-generation semiconductor material in various fields.

A Patent Document 1 (Japanese Patent Application Laid-open Publication No. 2021-4173) describes that crystal strain of a compound semiconductor substrate is evaluated by a photoelasticity method. A Patent Document 2 (Japanese Patent Application Laid-open Publication No. 2022-18072) describes that an SiC single crystal substrate is manufactured by a vapor phase epitaxy (growth) method. A Non-Patent Document 1 (K. Kusunoki et al., Mater. Sci. Forum Vol. 963 (2018) pp 85 to 88) describes that crystal growth conditions in growth of SiC single crystal by a solution growth method are optimized based on simulation. The optimization is for suppressing formation of polycrystal SiC called miscellaneous crystal in a solution. H. A Non-Patent Document 2 (Tsuge et al, Mater. Sci. Forum Vol. 740 to 742 (2013) pp 7 to 10) describes that a sublimation recrystallization method is used as a method of growing SiC single crystal.

### SUMMARY OF THE INVENTION

As described in the Non-Patent Document 1, it is known that the formation of the miscellaneous crystals is suppressed by the optimization of crystal growth conditions based on simulation. However, crystal growth conditions are not optimized based on simulation aiming at a decrease in thermal strain of SiC single crystal.

In consideration of the above circumstances, an objective of the present disclosure is to suppress occurrence of thermal strain during crystal growth, thereby achieving high-quality SiC single crystal with small crystal defect density.

An SiC single crystal substrate according to one embodiment is an SiC single crystal substrate including a first main surface and a second main surface opposite to the first main surface, and the first main surface is a surface which tilts relative to a {0001} plane at an off-cut angle equal to or larger than 0° and equal to or smaller than 8°. A distribution of phase differences is obtained by measuring a phase difference between a first emission light and a second emission light emitted from the second main surface by making an incident light with two mutually perpendicular polarization components and a wavelength of 520 nm into the first main surface, and an average value of the phase differences is equal to or smaller than 10 nm while the maximum value of the phase differences is equal to or smaller than 70 nm.

A method of manufacturing an SiC single crystal according to one embodiment includes a step (a) of growing the SiC single crystal by bringing a lower surface of a seed crystal substrate into contact with a solution containing silicon (Si) and carbon (C). In the step (a), the SiC single crystal is grown under a condition that an in-plane temperature difference in a contact interface between the lower surface of the seed crystal substrate and the solution is equal to or smaller than 4.0°C while a temperature gradient upward from an upper surface opposite to the lower surface of the seed crystal substrate is equal to or larger than 9 °C/cm and equal to or smaller than 25 °C/cm.

An apparatus of manufacturing SiC single crystal according to one embodiment includes: a seed crystal holding shaft including a cylinder and enabling a seed crystal substrate to be held under the cylinder; a side-surface heat insulating member provided in the cylinder; and an upper-surface heat insulating member provided in the cylinder. The seed crystal substrate has a lower surface enabled to be in contact with a solution housed in a crucible, and an upper surface opposite to the lower surface. The solution contains Si and C. An inner diameter of the cylinder is equal to or larger than a diameter of the seed crystal substrate. The side-surface heat insulating member has such a length that a part of the side-surface heat insulating member is enabled to be upper than an upper end of the crucible when the lower surface of the seed crystal substrate is brought into contact with the solution. The upper-surface heat insulating member is away upward from the upper surface of the seed crystal substrate.

According to one embodiment, occurrence of thermal strain during crystal growth is suppressed, thereby achieving high-quality SiC single crystal with small crystal defect density.

### BRIEF DESCRIPTIONS OF THE DRAWINGS

FIG. 1 is a cross-sectional view illustrating an apparatus of manufacturing single crystal according to first to fourth working examples;
FIG. 2 is a cross-sectional view illustrating part of the apparatus of manufacturing single crystal according to the first to fourth working examples;
FIG. 3 is a cross-sectional view illustrating an apparatus of manufacturing single crystal according to a first comparative example;
FIG. 4 is a cross-sectional view illustrating an apparatus of manufacturing single crystal according to a second comparative example;
FIG. 5 is a cross-sectional view illustrating an apparatus of manufacturing single crystal according to a third comparative example;
FIG. 6 is a cross-sectional view illustrating part of the apparatus of manufacturing single crystal according to the third comparative example;
FIG. 7 is a cross-sectional view illustrating an apparatus of manufacturing single crystal according to a fourth comparative example;
FIG. 8 is a cross-sectional view illustrating the apparatus of manufacturing single crystal according to the fourth comparative example;
FIG. 9 is a table illustrating evaluation results of the working examples and the comparative examples;
FIG. 10 is a graph illustrating a relationship between a position on a seed crystal substrate and a temperature difference;
FIG. 11 is a graph illustrating a relationship between a temperature and a distance upward from an upper surface of a seed crystal according to the third working example;
FIG. 12 is an enlarged cross-sectional view illustrating the apparatus of manufacturing single crystal according to the third working example;
FIG. 13 is a graph illustrating a relationship between a temperature and a distance upward from an upper surface of a seed crystal according to the fourth comparative example;
FIG. 14 is an enlarged cross-sectional view illustrating the apparatus of manufacturing single crystal according to the fourth comparative example;
FIG. 15 is a cross-sectional view illustrating an apparatus of manufacturing single crystal according to a first modification example;
FIG. 16 is a cross-sectional view illustrating an apparatus of manufacturing single crystal according to a second modification example;
FIG. 17 is a cross-sectional view illustrating an apparatus of manufacturing single crystal according to a third modification example; and
FIG. 18 is a cross-sectional view illustrating an apparatus of manufacturing single crystal according to a fourth modification example.

### DESCRIPTIONS OF THE PREFERRED EMBODIMENTS

The same components are denoted by the same reference signs throughout all the drawings for explaining the embodiments, and the repetitive description thereof will be omitted. Note that even a plan view may be hatched so as to make the drawing easy to see.

### (FIRST EMBODIMENT)

The following explanation is about a decrease in phase differences of the SiC single crystal by adjusting growth conditions when the SiC single crystal is grown by a solution growth method, thereby manufacturing high-quality SiC single crystal with small thermal strain.

### <ROOM TO BE IMPROVED>

A method of growing the SiC single crystal is roughly classified into a vapor phase growth method and a liquid phase growth method. The former includes a sublimation recrystallization method and a high-temperature chemical vapor deposition method. The latter includes a solution growth method.

The sublimation recrystallization method as one of the vapor phase growth methods is a method of growing SiC single crystal by heating and sublimating a solid material made of powdery SiC at a high temperature, and then, recrystallizing it in contact with a low-temperature seed crystal substrate. The sublimation recrystallization method is disadvantageous in that crystal defects such as hollow defect, lattice defect, and foreign polytypes easily occur in the grown single crystal. However, the sublimation recrystallization method increases a crystal growth rate. Thus, SiC single crystal is manufactured by the sublimation recrystallization method in many cases.

The high-temperature chemical vapor deposition method as one of the vapor phase growth methods is a method of growing SiC single crystal by supplying source gas and carrier gas into a high-temperature reactor and crystallizing Si gas and Si₂C gas, which are molecular species formed by reaction of the source gas in the high-temperature reactor, in contact with a seed crystal substrate. The high-temperature chemical vapor deposition method can provide higher-purity crystal than that of the sublimation recrystallization method, and besides, is a promising method for high-yield growth, because of using high-temperature gas. However, the high-temperature chemical vapor deposition method is disadvantageous in terms of a decrease in crystal defects.

To the contrary, the solution growth method as one of the liquid phase growth methos is a method of growing SiC single crystal by melting silicon (Si) or Si and an alloy in a graphite-made crucible, dissolving carbon (C) from the crucible into melt, and growing it on a lower surface of a seed crystal substrate. The solution growth method is a promising method for the decrease in crystal defects since a state of the crystal growth to be made is more nearly thermal equilibrium than those of the sublimation recrystallization method and the high-temperature vapor deposition method.

However, in the solution growth method, if a temperature difference in the solution increases, the parasitic polycrystalline SiC formations called miscellaneous crystal is formed in the solution and on the inner wall of the crucible in contact with the solution. This is not preferable since the miscellaneous crystal floats around the seed crystal and adheres to the seed crystal substrate, thereby inhibiting the single crystal growth. For suppressing the formation of the miscellaneous crystal, it is effective to unify a temperature distribution in the solution. However, when the temperature distribution in the solution is unified, the formation of miscellaneous crystal can be suppressed while the single crystal growth on the seed crystal substrate may not proceed. Thus, a development for unifying the temperature distribution in the solution and to grow the crystal is necessary.

Thus, the present inventors have studied that a heat insulating member is arranged on at least a part of the side surface of the seed crystal holding shaft. The present inventors have found that a heat radiating path of the seed crystal holding shaft in an up-and-down direction can be formed by such arrangement of the heat insulating member, thereby unifying the temperature distribution in the solution and locally decreasing the temperature around the seed crystal substrate. However, at the same time, the present inventors have found that the thermal strain still remains in the grown crystal in only the arrangement of the heat insulating member on the side surface of the seed crystal holding shaft since an in-plane temperature distribution on an upper surface of the seed crystal substrate (a back surface of the seed crystal) is still large.

The occurrence of thermal strain causes the crystal defects. The crystal defects are, for example, basal plane dislocation (BPD). The basal plane dislocation density in SiC single crystal is proportional to a value of the thermal strain in the SiC single crystal. Thus, in order to manufacture SiC single crystal with less crystal defects, an approach of performing crystal growth simulation aiming at a decrease in thermal strain and optimizing the crystal growth conditions is considerable. However, it is difficult to measure thermal strain in SiC single crystal by simulation or experiment.

From the above, in order to suppress the formation of the crystal defects in manufacturing SiC single crystal, it is desirable to suppress the occurrence of the thermal strain in SiC single crystal and decrease stress in the SiC single crystal substrate obtained from the SiC single crystal.

### <EVALUATION OF CRYSTAL DEFECTS>

Next, regarding a method of evaluating a decreasing effect of the crystal defect, its result studied by the present inventors will be described.

The present inventors have found that the magnitude of thermal strain in SiC single crystal is almost proportional to a phase difference between two refracted lights having passed through the SiC single crystal substrate, caused by birefringence when a light is emitted to the SiC single crystal substrate. That is, by the evaluation of the phase difference, the thermal strain as a cause of the formation of the crystal defects can be indirectly evaluated.

First, the birefringence will be described. The light has components that are not only amplitude (brightness) and wavelength (color) but also polarization (oscillation direction). The polarization of the light can be decomposed into two mutually perpendicular polarization components. For example, an incident light on an object has a first polarization component and a second polarization component which have different oscillation planes from each other. The first polarization component is, for example, an "x" component which oscillates along an x axis perpendicular to a travelling direction of the incident light. The second polarization component is, for example, a "y" component which oscillates along a y axis perpendicular to the travelling direction of the incident light. The x axis and the y axis are perpendicular to each other.

When the light passes through the object, the larger the refractive index of the object is, the longer the passing time of the light is. To the contrary, the birefringence means that when the light passes through the object, the traveling speed of the light changes depending on the orientation of the oscillation plane of the light. If the incident light has the first polarization component and the second polarization component, the first polarization component passes through the object to be, for example, slower than the second polarization component. Consequently, there is a phase difference by a difference in the passing speed between a first emission light including the first polarization component and a second emission light including the second polarization component emitted from the object. When the incident light is made incident on the object, the first polarization component and the second polarization component refract at different refractive indexes from each other because of the birefringence. Thereby, two emission lights with different emission angles from each other are emitted from the object.

When the light passes through the object which causes the birefringence, a polarization state of the light is changed by photoelasticity. That is, the occurrence of the phase difference means the change of the polarization state. Thus, the birefringence can be evaluated by comparison between the polarization states before and after the light passes through the object.

The birefringence occurs due to a material of the object or stress of the object. For example, when the light passes through a certain object, while the birefringence does not occur when the stress of the object is zero, the birefringence occurs when the object has the stress. The larger the stress of the object through which the light passes is, the larger the phase difference between the polarization components caused by the birefringence is. The magnitude of the phase difference to be caused is proportional to the stress, and the proportionality coefficient (photoelectricity coefficient) is constant for each material.

A distribution of the birefringence of the object can be expressed as quantitative data and be visualized by use of a polarization image sensor and computation/image processing software. That is, a polarization image sensor with a photonic crystal filter incorporated can capture invisible polarization information as an image. The distribution of the birefringence can be expressed as quantitative data and be visualized by emission of light to a plurality of points of the object and analyzation of an image including a plurality of items of resultant polarization information by use of the computation/image processing software.

The birefringence is almost proportional to the phase difference. Thus, the phase difference can be used as a parameter indicating the degree of the residual stress of the object. In other words, the value of the phase difference is proportional to the value of strain of the object. Particularly, if the object is made of substantially the same material in the thickness direction such as SiC single crystal while the thickness of the object is substantially uniform, reliability of the phase difference as the parameter indicating the strain of the object increases.

In the sublimation recrystallization method described above, the temperature gradient and the temperature distribution are large during crystal growth, and only crystal with large residual strain is obtained. Consequently, in the sublimation recrystallization method, it is difficult to provide the high-quality SiC single crystal substrate in which an average value of phase differences is smaller than 15 nm.

The present inventors have paid attention to the fact that the correlation between the phase difference caused by the birefringence and the stress in SiC single crystal exists when the light is emitted to the SiC single crystal, and the present inventors have found a method of evaluating the degree of crystal defects in SiC single crystal by use of the values of phase differences and the distribution of the phase differences. Further, the present inventors have found that in the emission of the light to SiC single crystal and the analyzation of the phase difference between two emission lights having passed through the SiC single crystal at the plurality of points, SiC single crystal with less crystal defects can be provided by decrease in each of the average value of the phase differences and the maximum value of the phase differences.

### <MANUFACTURE OF SiC SINGLE CRYSTAL BY SOLUTION GROWTH METHOD>

The present inventors have studied a method of manufacturing a 4H-polytype SiC single crystal substrate with less crystal defects by use of the phase difference as an evaluation index. In the course of the study, the present inventors have studied that the SiC single crystal is grown by the solution growth method.

The present inventors have found that a crystal in-plane temperature difference can be reduced to be equal to or smaller than 4.0°C by arranging a heat insulating member on the side surface in the seed crystal holding shaft and further arranging a heat insulating member on at least part of the upper surface of the seed crystal substrate. The present inventors have additionally found that a temperature gradient as a crystal growth driving force is set to be equal to or larger than 9 °C/cm and equal to or smaller than 25 °C/cm, the temperature gradient being in a vertical direction (upward direction) from the upper surface of the seed crystal substrate, thereby securing the crystal growth driving force, which is strong enough to obtain bulk crystal. Consequently, the present inventors have found that this manner can provide the SiC single crystal substrate with the phase-difference average value that is smaller than 10 nm.

A solution containing silicon (Si) and carbon (C) may be referred to as Si-C solution in the present specification. SiC single crystal, which is grown on the lower surface of a seed crystal substrate or a surface of the seed crystal substrate closer to the Si-C solution, is referred to as grown crystal.

### SIMULATION OF CRYSTAL GROWTH AND EVALUATION OF SiC SINGLE CRYSTAL SUBSTRATE

The present inventors have created a variety of analytical models of a single crystal growing apparatus, and have simulated the crystal growth of SiC single crystal under various manufacturing conditions by use of the analysis models. The present inventors have further created an apparatus of manufacturing single crystal with a configuration similar to those of the analysis models of apparatuses of manufacturing single crystal used for the multiple types of crystal growth simulations, and have made the SiC single crystal growth experiments and have manufactured the SiC single crystal substrate by use of the apparatus of manufacturing single crystal. The present inventors have evaluated the temperature distribution in the apparatus of manufacturing single crystal based on the crystal growth simulation, and have evaluated the phase difference by use of the SiC single crystal substrate obtained by the growth experiments. The crystal growth simulation of the SiC single crystal, the growth experiments of the SiC single crystal, the manufacturing of the SiC single crystal substrate, and the evaluation of the SiC single crystal substrate, which have been performed by the present inventors under a plurality of manufacturing conditions, will be described below. That is, each of working examples and comparative examples described later will be sequentially described.

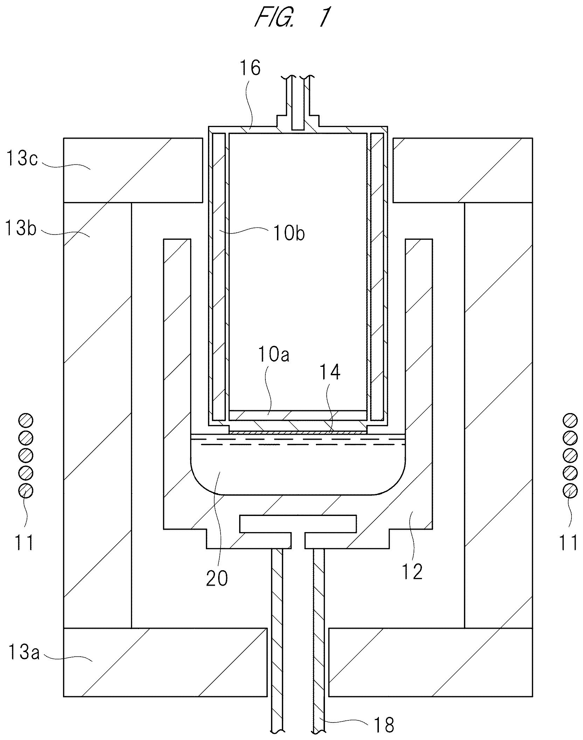

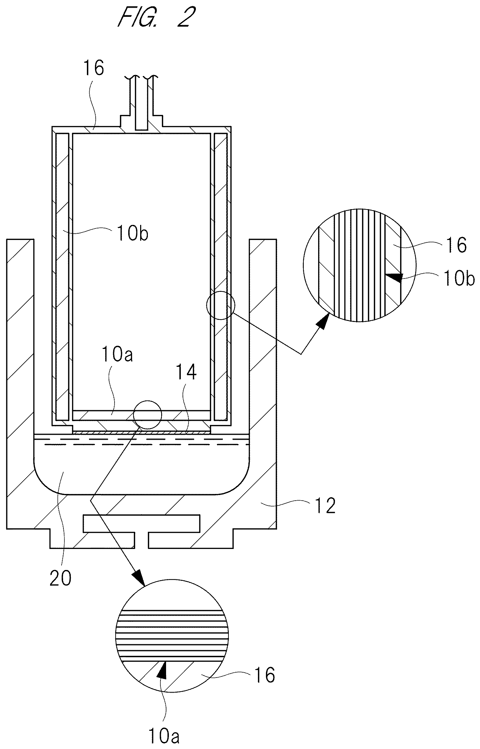

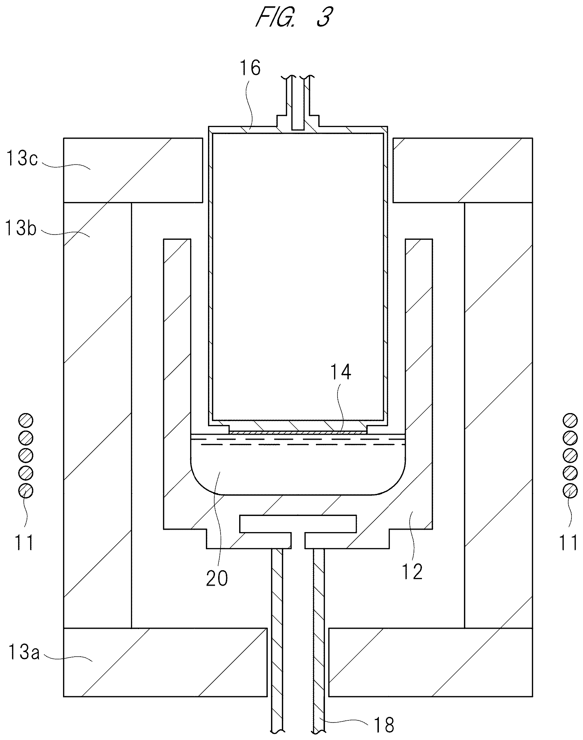

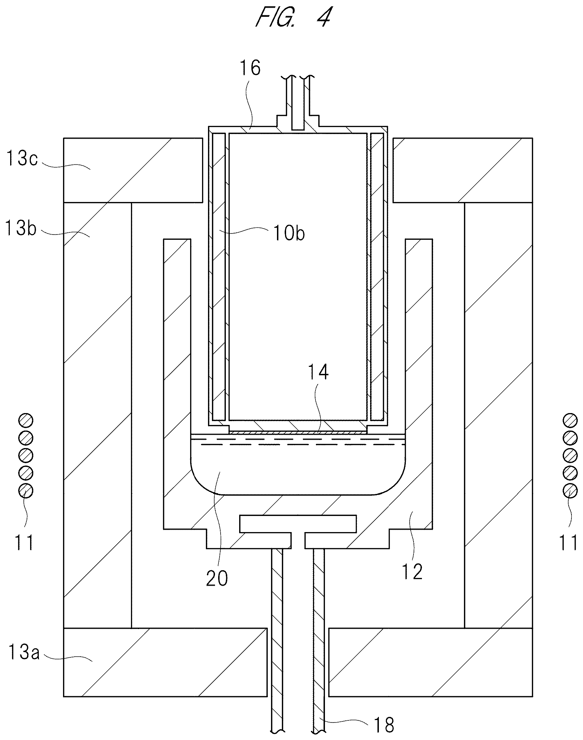

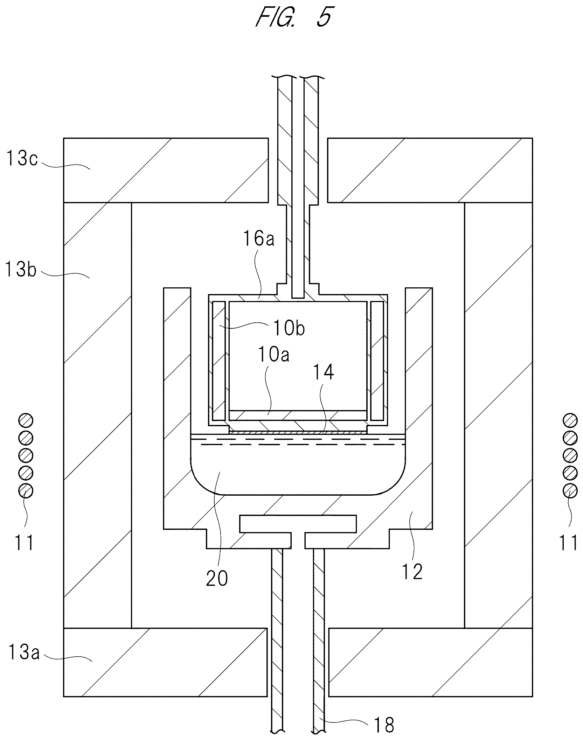

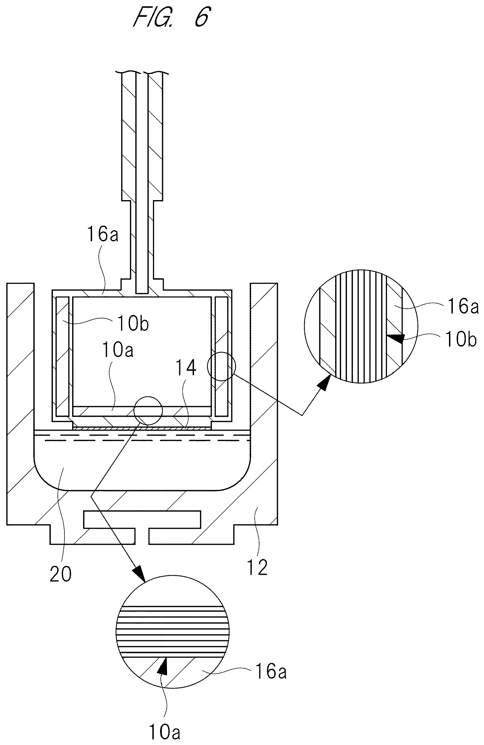

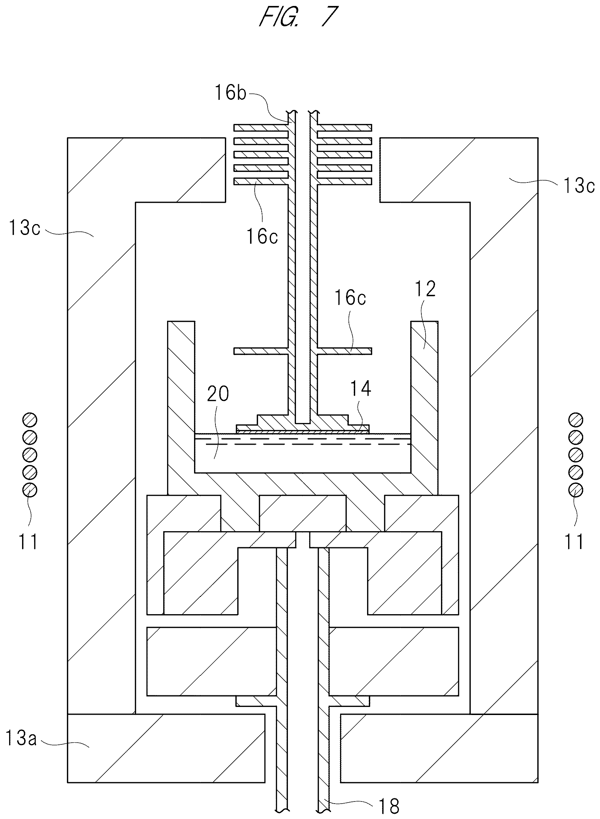

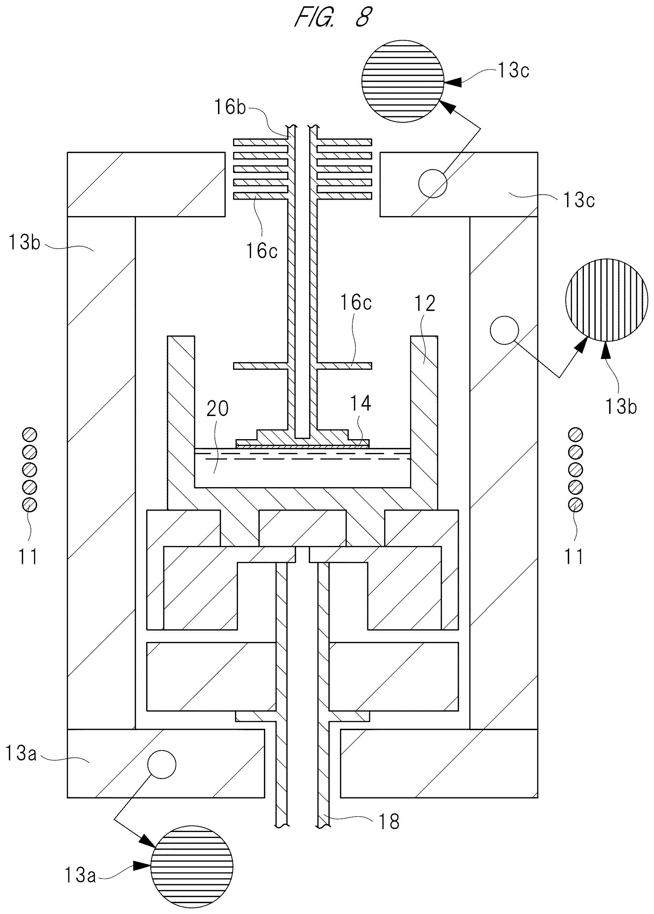

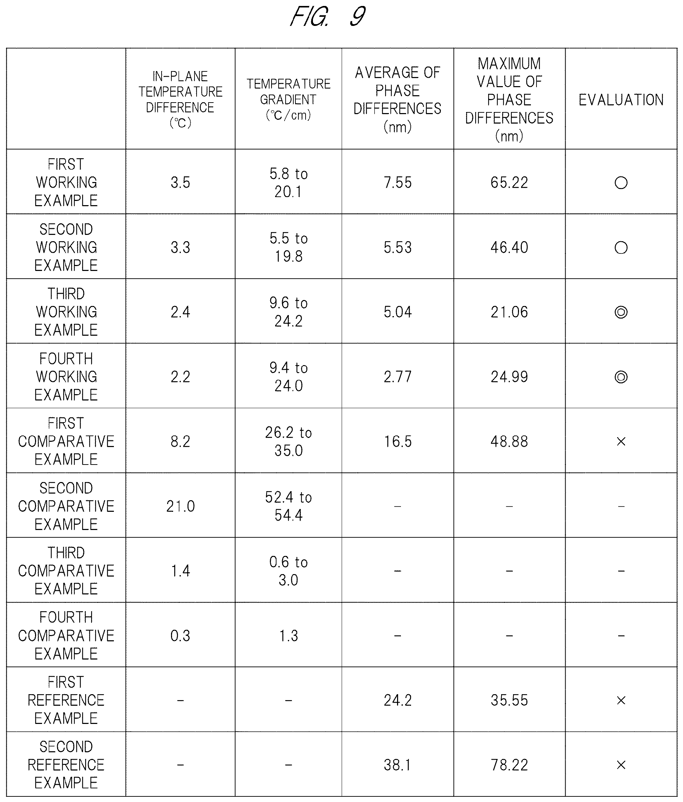

FIGs. 1 to 8 illustrate configurations of apparatuses of manufacturing single crystal used for the crystal growth simulation and the growth experiments of the SiC single crystal. FIG. 1 is a cross-sectional view illustrating an apparatus of manufacturing single crystal commonly used in first to fourth working examples. FIG. 2 is a cross-sectional view illustrating part of the apparatus of manufacturing single crystal commonly used in the first to fourth working examples. FIG. 3 is a cross-sectional view illustrating an apparatus of manufacturing single crystal used in a first comparative example. FIG. 4 is a cross-sectional view illustrating an apparatus of manufacturing single crystal used in a second comparative example. FIG. 5 is a cross-sectional view illustrating an apparatus of manufacturing single crystal used in a third comparative example. FIG. 6 is a cross-sectional view illustrating part of the apparatus of manufacturing single crystal used in the third comparative example. FIGs. 7 and 8 are cross-section views each illustrating an apparatus of manufacturing single crystal used in a fourth comparative example. FIG. 9 is a table illustrating the evaluation results of the working examples and the comparative examples.

### (COMMON CONDITIONS)

First, the common conditions (such as configuration of the manufacturing apparatuses and the manufacturing conditions thereof) among the working examples and the comparative examples described later will be described.

The present inventors have simulated the temperature distributions in the crystal growth furnace and in the solution when the SiC single crystal is grown by the solution growth method by use of the simulation software (CGSim manufactured by STR Japan, Ver. 20.1) for the bulk crystal growth from the solution. The present inventors have created analysis models of the apparatuses of manufacturing single crystal each having the configurations of FIGs. 1 to 8 in order to simulate the crystal growth. The present inventors have further created an apparatus of manufacturing single crystal having a configuration similar to those of the analysis models of the apparatuses of manufacturing single crystal used for simulating the crystal growth, and have made the growth experiments of the SiC single crystal by use of the apparatus of manufacturing single crystal.

Next, the configuration of the apparatus of manufacturing single crystal, commonly used among the working examples and the comparative examples described later will be described.

For example, as illustrated in FIG. 1, the apparatus of manufacturing single crystal includes a heat insulating member 13b configuring a hot zone. The heat insulating member 13b is a cylindrically molded heat insulating member. The heat insulating member 13b has an outer diameter of 530 mm, an inner diameter of 390 mm, and a height of 420 mm. An opening at the upper end of the heat insulating member 13b is connected to a disk-shaped heat insulating member 13c with an opening at its center. An opening at the lower end of the heat insulating member 13b is connected to a disk-shaped heat insulating member 13a with an opening at its center.

A graphite-made crucible 12 is arranged in the cylindrical heat insulating member 13b. The crucible 12 has a cylinder configuring the sidewall and a disk configuring a bottom surface. The crucible 12 has an outer diameter of 270 mm, an inner diameter of 240 mm, and a height of 250 mm. A curvature of R50 is set at the corners of the inner bottom of the crucible 12. In the fourth comparative example, a curvature is not set at the corners of the inner bottom of the crucible 12. The Si-C solution is arranged (stored) in the crucible 12. The inside of the apparatus of manufacturing single crystal is under argon atmosphere. As the heating device, a five-turn coil (high-frequency coil) 11 with a diameter of 600 mm and a height of 90 mm is horizontally arranged around the crucible 12 via the molded heat insulating member 13b. The coil 11 is arranged vertically on a line at a position of 165 mm horizontally away from the side surface of the crucible 12 such that the middle height position of the coil 11 in the vertical direction is equal to a 50-mm height position from the bottom surface of the crucible 12.

Next, a method of forming the Si-C solution, which is common among the working examples and the comparative examples, will be described.

At first, the Si-C solution is formed in the crucible 12. In this case, in the crucible 12, silicon (Si), chromium (Cr), and molybdenum (Mo) serving as the melt raw materials are stored at a ratio of "55:40:5" in unit of at%. Then, the coil 11 arranged around the crucible 12 is energized to heat and melt the raw materials in the crucible 12, thereby forming the melt of Si/Cr/Mo alloy. Then, a sufficient amount of C from the crucible 12 is dissolved into the melt of Si/Cr/Mo alloy, thereby forming the Si-C solution 20 with a height of about 50 mm. As separate from the growth experiments, the growth temperature is confirmed by inserting a thermocouple in which a zirconia-coated tungsten-rhenium baring wire is inserted into a graphite-made protection tube, into the seed crystal holding shaft, and measuring the surface temperature of the Si-C solution 20 under the same conditions as those of the growth experiments.

Next, the SiC single crystal substrate and a method of evaluating the same will be described.

The crystal is grown by the solution growth method in the growth experiments of the SiC single crystal. Then, a substrate cut out from the grown crystal is obtained. Next, a first main surface of the substrate and a second main surface opposite to the first main surface are ground and then polished. Thereby, a 4H-SiC single crystal substrate (wafer) with a 4° off-cut surface is obtained.

The SiC single crystal substrate has a first main surface and a second main surface opposite to the first main surface, and is made of the polytype-4H SiC. The first main surface is tilted relative to the {0001} plane at an off-cut angle. The off-cut angle may be, for example, equal to or larger than 0° and equal to or smaller than 8°. The off-cut angle is preferably, for example, larger than 0° and equal to or smaller than 4.5°, and more preferably, for example, equal to or larger than 2° and equal to or smaller than 4°.

The first main surface of the SiC single crystal substrate is so-called Si face on which silicon (Si) atoms are terminated, and the second main surface thereof is so-called C face on which carbon (C) atoms are terminated. The thickness direction of the SiC single crystal substrate is a direction heading from the first main surface toward the second main surface. The maximum diameter of the first main surface is equal to or larger than 140 mm. The maximum diameter of the first main surface may be preferably equal to or larger than 150 mm, more preferably equal to or larger than 190 mm, and much more preferably equal to or larger than 200 mm.

The present inventors have obtained the phase difference distribution of the SiC single crystal substrate (described in detail later). At first, the present inventors have emitted an incident light with a wavelength of 520 nm to the first main surface of the SiC single crystal substrate along the <0001> direction (c axis). The <0001> direction is perpendicular to the {0001} plane. The incident light has a first polarization component and a second polarization component. The first polarization component oscillates along, for example, a first direction perpendicular to a traveling direction of the incident light. The second polarization component oscillates along, for example, a second direction perpendicular to the traveling direction of the incident light. The first direction and the second direction are perpendicular to each other. The phase difference between the first polarization component and the second polarization component in the incident light is, for example, zero. Next, the present inventors have measured the phase difference which is a difference between a phase of a first emission light including the first polarization component and a phase of a second emission light including the second polarization component out of the emission light having passed through the SiC single crystal substrate and having emitted from the second main surface.

The phase difference is measured at, for example, a plurality of measurement points on the first main surface of the SiC single crystal substrate, thereby obtaining the phase difference distribution. The number of the measurement points on the first main surface is, for example, ten. The larger the number of the measurement points is, the more accurate the phase difference distribution is, and thus, the larger number of the measurement points is preferable, and it is more desirable to measure the phase difference on the entire SiC single crystal substrate. For example, in an image with several million pixels, when the phase difference is measured on the entire SiC single crystal substrate, thereby obtaining the accurate phase difference distribution of the SiC single crystal substrate. That is, the phase difference is measured on each of the several million points segmented in a matrix pattern on the first main surface of the SiC single crystal substrate, thereby obtaining the accurate phase difference distribution of the SiC single crystal substrate. The present inventors have measured the phase difference on the entire SiC single crystal substrate, thereby obtaining the phase difference distribution in the SiC single crystal substrate, and measuring the average value and the maximum value of the values of the phase differences in the phase difference distribution.

The phase difference distribution in the SiC single crystal substrate is quantified and visualized by use of an apparatus such as 2-dimensional Birefringence Measurement System WPA300L produced by Photonic Lattice, Inc. In the measurement of the phase difference distribution in the SiC single crystal substrate obtained in the growth experiments, the phase difference distribution in the SiC single crystal substrate is quantified and visualized by use of this 2-dimensional Birefringence Measurement System WPA300L.

Next, the physical property values of the solution and the physical property values of the respective members embedded in the single crystal growing apparatus will be described. The SiC solution 20 has physical properties at 2000°C that are a density of 3948 kgm⁻³, a viscosity of 2.49 × 10⁻³ Pa·s, an electric conductivity of 1.23 × 10⁶ Sm⁻¹, a heat conductivity of 66.5 W/(m·K), a specific heat of 791 Jkg⁻¹K⁻¹, and a radiation factor of 0.3. Each of the crucible 12 and the seed crystal holding shaft is made of graphite, and has physical properties at 2000 °C that are a heat conductivity of 36 W/(m·K), an electric conductivity of 9.14 × 10⁴ Sm⁻¹, and a radiation factor of 0.8. The molded heat insulating member 13b has physical properties at 2000 °C that are a density of 0.13 g/cm³, an electric conductivity of 8.08 × 10² Sm⁻¹, a heat conductivity of 0.47 W/(m·K), and a radiation factor of 0.6. A felt described later has physical properties at 2000 °C that are an electric conductivity of 0 Sm⁻¹ and a heat conductivity of 0.40 W/(m·K). Argon has a physical property at 2000 °C that is a heat conductivity of 0.06 W/(m·K) at 2000 °C. The coil 11 has a temperature of 300K. The oscillation frequency for high-frequency heating by the coil 11 is 2 kHz.

Next, the specific conditions of the plurality of working examples and the plurality of comparative examples illustrated in FIGs. 1 to 8 will be described. Note that the evaluation results of the working examples and the comparative examples will be described later.

### (FIRST WORKING EXAMPLE)

The specific conditions of the first working example illustrated in FIG. 1 will be described below. In the first working example, the seed crystal holding shaft 16 is made of graphite. The seed crystal holding shaft 16 includes a cylinder (with an inner diameter of 200 mm) and a disk connected to a tip of the cylinder to close an opening of the cylinder. The cylinder has a diameter of 210 mm and a height of 296 mm. The disk has a thickness of 10 mm and a diameter of 146 mm. The seed crystal substrate 14 is a disk-shaped 4H-SiC single crystal with a thickness of 0.8 mm and a diameter of 150 mm. The seed crystal substrate 14 is made of a disk-shaped 4H-SiC single crystal created by sublimation and having a {000-1} plane with a 4 ° off-cut angle. The seed crystal substrate 14 is attached to the tip of the seed crystal holding shaft 16 by a carbon adhesive material via a disk-shaped graphite member with a diameter of 146 mm and a thickness of 10 mm. The inner diameter of the cylinder of the seed crystal holding shaft 16 is equal to or larger than the diameter of the seed crystal substrate 14. FIG. 1 illustrates the graphite member integrated with the seed crystal holding shaft 16.

The {0001} plane as the upper surface of the seed crystal substrate 14 is attached substantially to the center of the lower surface of the seed crystal holding shaft 16 such that the lower surface of the seed crystal substrate 14 is the {000-1} plane. The lower surface of the seed crystal substrate 14 is a surface in contactable with the Si-C solution 20. The upper surface of the seed crystal substrate 14 is held at the center of the lower surface of the seed crystal holding shaft 16 that is movable in the up-and-down direction.

The seed crystal holding shaft 16 and the seed crystal substrate 14 are arranged inside the heat insulating member 13b through the opening provided in the disk-shaped heat insulating member 13c arranged on the upper side of the crucible 12. The opening has a diameter of 220 mm. The gap between the heat insulating member 13c and the seed crystal holding shaft 16 at the opening is 5 mm.

The crucible 12 is connected to a cylindrical crucible holding shaft 18 for holding the crucible 12. The crucible holding shaft 18 is configured to be movable in the up-and-down direction. The crucible holding shaft 18 is rotatably supported with its cylindrical shaft as a rotation axis. Thereby, the crucible 12 attached to the crucible holding shaft 18 can be moved in the up-and-down direction and rotated in the horizontal direction by the crucible holding shaft 18. The crucible holding shaft 18 is hollow, and is configured to measure a temperature by inserting a thermocouple or radiation thermometer into its hollow inside.

In the first working example, a heat insulating member (side-surface heat insulating member) 10b with an outer diameter of 200 mm, a thickness of 20mm, and a height of 275 mm is inserted into the cylinder (the side surface) of the seed crystal holding shaft 16. The heat insulating member 10b is arranged between the outer wall and the inner wall of the cylinder in this case. However, the heat insulating member 10b may be arranged inside the inner wall of the cylinder, in other words, inside the cylinder. Alternatively, the inner wall of the cylinder may be eliminated. A heat insulating member (molded heat insulating member, upper-surface heat insulating member) 10a with a diameter of 150 mm and a thickness of 10 mm is arranged at the tip (lower end) of the seed crystal holding shaft 16 inside the seed crystal holding shaft 16. The heat insulating member 10b is so high that part of the heat insulating member 10b can be upper than the upper end of the crucible 12 when the lower surface of the seed crystal substrate 14 is brought into contact with the Si-C solution 20. Part of the heat insulating member 10b is arranged at the same height position as that of the heat insulating member 13c when the lower surface of the seed crystal substrate 14 is brought into contact with the Si-C solution 20. The disk of the seed crystal holding shaft 16 is inserted between the heat insulating member 10a and the seed crystal holding shaft 16.

Each of the heat insulating members 10a, 10b, 13a, 13b, and 13c is made of nonwoven fabric in which pitch-based carbon fibers are intertwined. The nonwoven fabric is carbonaceous or graphitic felt. The heat insulating members 10a, 10b, 13a, 13b, and 13c may be made of a molded, cured, carbonized, and graphitized heat insulating material in which a resin having a high carbonization rate is infiltrated in the pitch-based carbon fiber. When the felt is used for the heat insulating member 10b, for example, a material with a bulk density of 0.1 g/cm³ is used for the felt. When a molded heat insulating material is used for the heat insulating member 10a, a material with a bulk density of about 0.13 g/cm³ to 0.16 g/cm³ is used for the molded heat insulating material. The molded heat insulating material has a thermal expansion coefficient of 2.2 × 10⁻⁶/K. The molded heat insulating material is more rigid than the felt, and thus, is easily kept in shape and is easily handled.

The heat insulating members 10a and 10b are arranged such that directions of their carbon fibers are perpendicular to the heat shielding directions. The heat insulating member 10a is arranged in order to shield heat in a direction perpendicular to the lower surface of the seed crystal holding shaft 16. The heat insulating member 10b is arranged in order to shield heat in a direction perpendicular to the side surface of the seed crystal holding shaft 16. The heat insulating member 10a has a circular bottom surface, and the bottom surface faces the upper surface of the seed crystal substrate 14. The cylindrical heat insulating member 10b faces the inner wall of the cylinder configuring the seed crystal holding shaft 16. As illustrated in FIG. 2, the fibers making the heat insulating member 10a extend along the upper surface of the seed crystal substrate. The fibers making the heat insulating member 10a may extend in a circumferential direction or a radial direction of the disk-shaped heat insulating member 10a. The fibers making the heat insulating member 10b extend along a central axis of the cylinder configuring the seed crystal holding shaft 16.

In the first working example, the heat insulating member 10a arranged inside the cylindrical seed crystal holding shaft 16 is a disk-shaped molded heat insulating member with a bulk density of 0.16 g/cm³ and a thickness of 10 mm. The heat insulating member 10a is positioned to be away upward by 15 mm from the upper surface of the seed crystal substrate via the graphite member.

Next, the operations of the apparatus of manufacturing single crystal according to the first working example, in other words, the crystal growing steps according to the first working example will be described.

In the crystal growing step using the apparatus of manufacturing single crystal according to the first working example, at first, the seed crystal holding shaft 16 is moved downward. Thereby, the lower surface of the seed crystal substrate 14 held by the seed crystal holding shaft 16 coincides with the upper surface of the Si-C solution 20. At this time, the entire lower surface of the seed crystal substrate 14 is wet with the Si-C solution 20. Then, the SiC single crystal is grown on the lower surface of the seed crystal substrate 14 while taking the seed crystal substrate 14 as a start point, by pulling up the seed crystal holding shaft 16 at a temperature of 2100°C while taking time for 40 hours. During the crystal growth, the crucible 12 is rotated at 5 rpm around the central axis of the seed crystal holding shaft 16. The seed crystal holding shaft 16 is automatically moved downward and upward by power controlled by, for example, a controller not illustrated.

After the crystal growth, a substrate, which is obtained by cutting out the solution growth part from the grown crystal, is ground and then polished. Thereby, the SiC single crystal substrate is obtained. The present inventors have obtained the temperature distribution in the apparatus of manufacturing single crystal by the crystal growth simulation, and have measured the phase difference by use of the SiC single crystal substrate.

### (SECOND WORKING EXAMPLE)

Next, the specific conditions of the second working example illustrated in FIG. 2 will be described. Even in matters not described in the section (COMMON CONDITIONS), the common conditions with those of the first working example will be described, and the repetitive description thereof will be omitted. The same goes for the third working example, the fourth working example, the first comparative example, the second comparative example, and the third comparative example.

In the second working example, the crystal is grown by use of the apparatus of manufacturing single crystal illustrated in FIGs. 1 and 2. The configuration of the apparatus of manufacturing single crystal according to the second working example is the same as that of the apparatus of manufacturing single crystal according to the first working example.

In the second working example, the crystal is grown under the same conditions as those of the first working example, except that a temperature during the crystal growth is 2000°C.

As similar to the first working example, the temperature distribution in the apparatus of manufacturing single crystal is obtained by the crystal growth simulation, and the phase difference is measured by use of the SiC single crystal substrate.

### (THIRD WORKING EXAMPLE)

In the third working example, the crystal is grown by use of the apparatus of manufacturing single crystal illustrated in FIGs. 1 and 2. The configuration of the apparatus of manufacturing single crystal according to the third working example is the same as that of the apparatus of manufacturing single crystal according to the first working example, except that the heat insulating member 10a has a thickness of 5 mm.

In the third working example, the crystal is grown by use of the apparatus of manufacturing single crystal under the same conditions as those of the first working example. Therefore, the repetitive description thereof will be omitted.

As similar to the first working example, the temperature distribution in the apparatus of manufacturing single crystal is obtained by the crystal growth simulation, and the phase difference is measured by use of the SiC single crystal substrate.

### (FOURTH WORKING EXAMPLE)

In the fourth working example, the crystal is grown by use of the apparatus of manufacturing single crystal illustrated in FIGs. 1 and 2. The configuration of the apparatus of manufacturing single crystal according to the fourth working example is the same as that of the apparatus of manufacturing single crystal according to the first working example.

In the fourth working example, the crystal is grown under the same conditions as those of the third working example except that a temperature during the crystal growth is 2000°C. Therefore, the repetitive description thereof will be omitted.

As similar to the first working example, the temperature distribution in the apparatus of manufacturing single crystal is obtained by the crystal growth simulation, and the phase difference is measured by use of the SiC single crystal substrate.

### (FIRST COMPARATIVE EXAMPLE)

In the first comparative example, the crystal is grown by use of the apparatus of manufacturing single crystal illustrated in FIG. 3. The configuration of the apparatus of manufacturing single crystal according to the first comparative example is the same as that of the apparatus of manufacturing single crystal according to the first working example, except that the cylindrical heat insulating member 10b and the disk-shaped heat insulating member 10a are not inserted into the cylindrical seed crystal holding shaft 16.

In the first comparative example, the crystal is grown by use of the apparatus of manufacturing single crystal under the same conditions as those of the first working example. Therefore, the repetitive description thereof will be omitted.

As similar to the first working example, the temperature distribution in the apparatus of manufacturing single crystal is obtained by the crystal growth simulation, and the phase difference is measured by use of the SiC single crystal substrate.

### (SECOND COMPARATIVE EXAMPLE)

In the second comparative example, the crystal is grown by use of the apparatus of manufacturing single crystal illustrated in FIG. 4. The configuration of the apparatus of manufacturing single crystal according to the second comparative example is the same as that of the apparatus of manufacturing single crystal according to the first working example, except that the disk-shaped heat insulating member 10a is not inserted in the cylindrical seed crystal holding shaft 16.

In the second comparative example, the crystal is grown by use of the apparatus of manufacturing single crystal under the same conditions as those of the first working example. Therefore, the repetitive description thereof will be omitted.

As similar to the first working example, the temperature distribution in the apparatus of manufacturing single crystal is obtained by the crystal growth simulation. However, in this case, the SiC single crystal cannot be grown, and the phase difference in the SiC single crystal substrate cannot be measured.

### (THIRD COMPARATIVE EXAMPLE)

In the third comparative example, the crystal is grown by use of the apparatus of manufacturing single crystal illustrated in FIGs. 5 and 6. The apparatus of manufacturing single crystal according to the third comparative example is different from the apparatus of manufacturing single crystal according to the first working example in that the heat insulating member 10c that is shorter in the up-and-down direction is used instead of the heat insulating member 10b and in that the seed crystal holding shaft 16a with the shorter cylinder is used. Specifically, as illustrated in FIG. 5, the seed crystal holding shaft 16a is a graphite-made shaft that connects a solid-core column (thin shaft) and a cylinder (thick shaft) and that includes a disk at a tip of the cylinder. The column has a diameter of 26 mm and a length of 227 mm. The cylinder has a diameter of 210 mm, a length of 156 mm, and an inner diameter of 200 mm. The disk has a thickness of 10 mm and a diameter of 146 mm. The heat insulating member 10c is arranged in the column of the seed crystal holding shaft 16a.

As illustrated in FIG. 6, the fibers making the heat insulating member 10a extend along the upper surface of the seed crystal substrate 14. The fibers making the heat insulating member 10a may extend in a circumferential direction or a radial direction of the disk-shaped heat insulating member 10a. The fibers making the heat insulating member 10b extend along the central axis of the cylinder configuring the seed crystal holding shaft 16a.

The seed crystal holding shaft 16a and the seed crystal substrate 14 are arranged at the opening provided in the disk-shaped heat insulating member 13c arranged on the upper side of the crucible 12 to pass through the thin shaft of the seed crystal holding shaft 16a. The opening has a diameter of 70 mm. The gap between the heat insulating member and the thin shaft of the seed crystal holding shaft 16a at the opening is 10 mm. The cylinder of the seed crystal holding shaft 16a is shorter than the cylinder of the seed crystal holding shaft 16 according to the first working example, and thus, the heat insulating member 10b in the seed crystal holding shaft 16a is also shorter by about 140 mm than the heat insulating member 10b according to the first working example.

In the third comparative example, the crystal is grown by use of the apparatus of manufacturing single crystal under the same conditions as those the first working example. Therefore, the repetitive description thereof will be omitted.

As similar to the first working example, the temperature distribution in the apparatus of manufacturing single crystal is obtained by the crystal growth simulation. However, in this case, the SiC single crystal cannot be grown, and the phase difference in the SiC single crystal substrate cannot be measured.

### (FOURTH COMPARATIVE EXAMPLE)

In the fourth comparative example, the crystal is grown by use of the apparatus of manufacturing single crystal illustrated in FIGs. 7 and 8.

As illustrated in FIG. 7, the seed crystal holding shaft 16b used in the fourth comparative example is configured such that a graphite-made disk is attached to a tip of a graphite-made column rod. The column rod has a diameter of 26 mm and a length of 282 mm. The disk has a diameter of 146 mm and a thickness of 10 mm. The seed crystal substrate 14 is a disk-shaped 4H-SiC single crystal with a thickness of 0.8 mm and a diameter of 150 mm. The upper surface of the seed crystal substrate 14 is held at the center of the lower surface of the seed crystal holding shaft 16b. FIG. 7 illustrates a (mount) which holds the crucible 12 and is held by the crucible holding shaft 18 between the crucible 12 and the crucible holding shaft 18. The seed crystal holding shaft 16b includes a plurality of fins 16c which are attached to cross the extending direction (the up-and-down direction) of the seed crystal holding shaft 16b.

As illustrated in FIG. 8, the fibers making the heat insulating members 13a and 13c along the upper surface of the seed crystal substrate 14 extend along the upper surface of the seed crystal substrate 14. The fibers making the cylindrical heat insulating member 13b surrounding the crucible 12 extend along the central axis of the cylinder. The same goes for other working examples and comparative examples.

In the fourth comparative example, the crystal is grown by use of the apparatus of manufacturing single crystal under the same conditions as those of the first working example. Therefore, the repetitive description thereof will be omitted.

As similar to the first working example, the temperature distribution in the apparatus of manufacturing single crystal is obtained by the crystal growth simulation. However, in this case, the SiC single crystal cannot be grown, and the phase difference in the SiC single crystal substrate cannot be measured.

### <EVALUATION RESULTS>

Next, the evaluation results of the first to fourth working examples, the first to fourth comparative examples, and the first and second reference examples will be described with reference to FIG. 9. The first and second reference examples show evaluation of a commercially-available SiC single crystal substrate with a diameter of 6 inches manufactured by the sublimation recrystallization method.

The in-plane temperature difference of the evaluation items is an in-plane temperature difference in a contact interface between the lower surface of the seed crystal substrate 14 and the Si-C solution 20. An in-plane temperature difference in the lower surface of the seed crystal holding shaft 16 is quantified by finding a temperature profile in a region from the center of the circular lower surface to a position away by 75 mm therefrom.

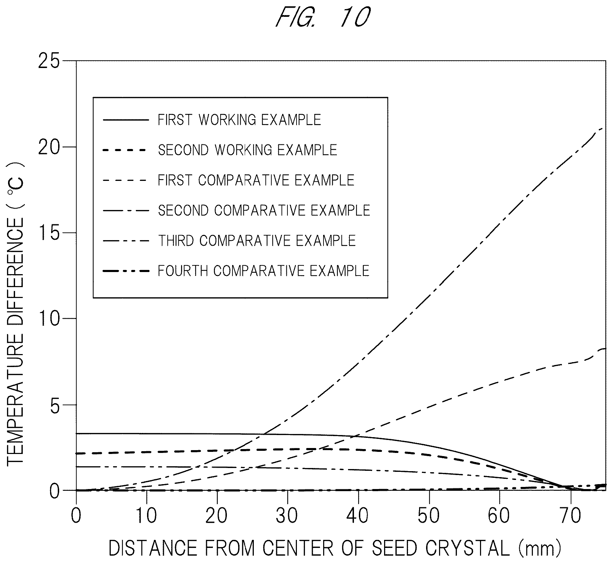

FIG. 10 is a graph illustrating a relationship between a position on the seed crystal substrate and the temperature difference. In FIG. 10, the horizontal axis indicates a distance from the center of the seed crystal substrate 14, and the vertical axis indicates a temperature difference in the upper surface of the seed crystal substrate 14. In FIG. 10, the graph of the first working example is illustrated with a solid line, the graph of the second working example is illustrated with a thick dashed line, the graph of the first comparative example is illustrated with a thinner dashed line, the graph of the second comparative example is illustrated with a dashed dotted line, the graph of the third comparative example is illustrated with a thinner dashed double-dotted line, and the graph of the fourth comparative example is illustrated with a thicker dashed double-dotted line. As illustrated in FIG. 10, in the first and second working examples and the third and fourth comparative examples, the in-plane temperature difference in the contact interface between the lower surface of the seed crystal substrate 14 and the Si-C solution 20 is equal to or smaller than 4.0°C. However, in the third and fourth comparative examples, the temperature difference is small, and therefore, the crystal is not grown.

For the temperature gradient of the evaluation items, the temperature profile in the vertical direction to the upper surface of the seed crystal substrate 14 is obtained at the center of the lower surface of the seed crystal holding shaft 16 and at positions each with 10-mm pitch in a region from the center to a position away by 60 mm, and a temperature gradient is quantified in a region from the upper surface of the seed crystal substrate 14 to a position away by 10 mm in the vertical direction.

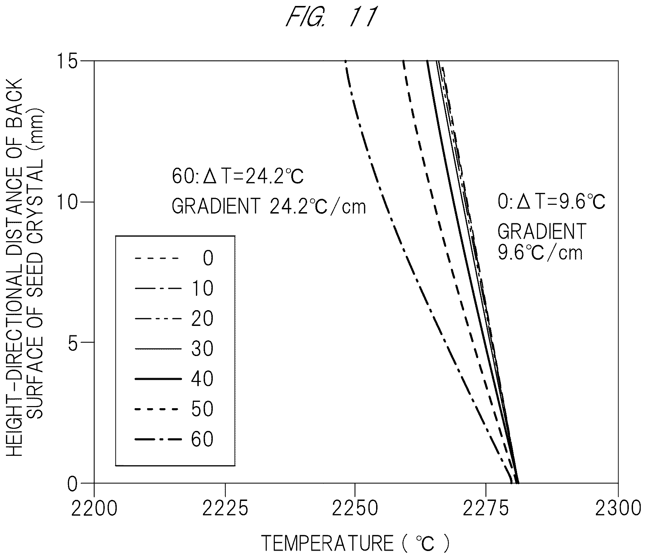

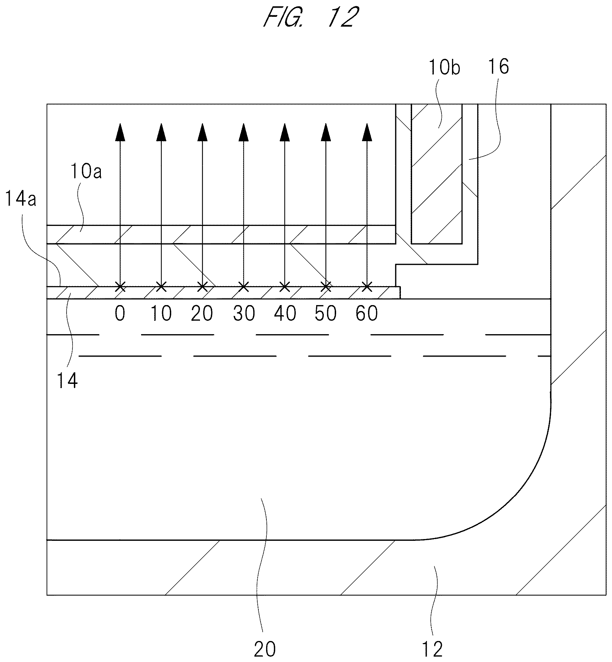

FIG. 11 is a graph illustrating a relationship between a temperature and a distance upward from the upper surface of the seed crystal substrate 14 according to the third working example. In FIG. 11, the horizontal axis indicates the temperature, and the vertical axis indicates the distance upward (the vertical direction) from the upper surface of the seed crystal substrate 14. The graph of FIG. 11 illustrates the upward temperature changes at respective seven positions away by 0 mm, 10 mm, 20 mm, 30 mm, 40 mm, 50 mm and 60 mm from the center of the upper surface 14a (see FIG. 12) of the circular seed crystal substrate 14. FIG. 12 is an enlarged cross-sectional view illustrating the apparatus of manufacturing single crystal. The seven measurement positions are illustrated with arrows in FIG. 12.

In FIG. 11, the graphs at the positions away by 0 mm, 10 mm, 20 mm, 30 mm, 40 mm, 50 mm and 60 mm from the center of the upper surface 14a are illustrated with the thinner dashed line, the thinner dashed dotted line, the dashed double-dotted line, the thinner solid line, the thicker solid line, the thicker dashed line, and the thicker dashed dotted line, respectively. In FIG. 11, the graphs at the positions away by 0 mm, 10 mm, 20 mm and 30 mm from the center of the upper surface 14a almost overlap one another. The temperature gradient at the position away by 0 mm is 9.6 °C/cm, and the temperature gradient at the position away by 60 mm is 24.2 °C/cm.

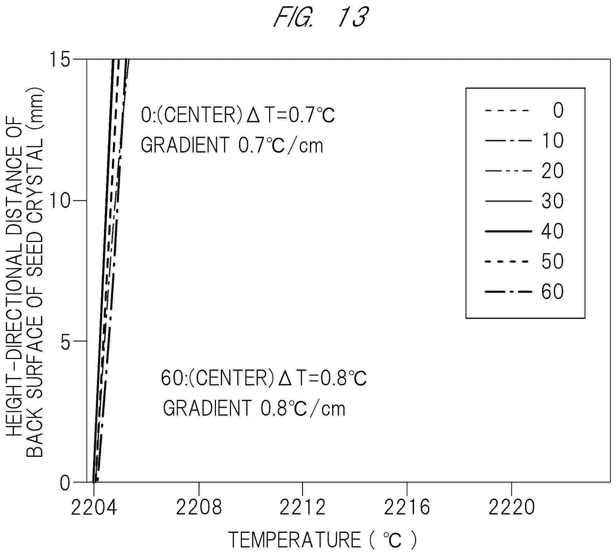

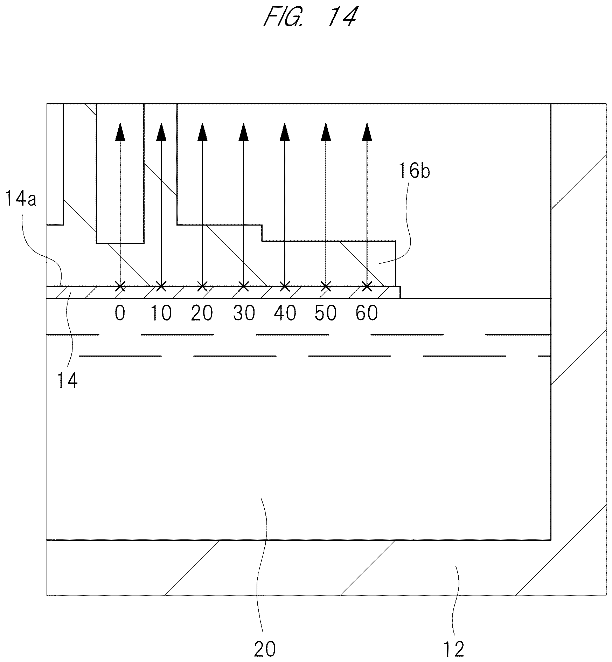

FIG. 13 is a graph illustrating a relationship between a temperature and a distance upward from the upper surface of the seed crystal substrate 14 according to the fourth comparative example. In FIG. 13, the horizontal axis indicates the temperature, and the vertical axis indicates the distance upward (the vertical direction) from the upper surface of the seed crystal substrate 14. The graph of FIG. 13 illustrates the upward temperature changes at respective seven positions away by 0 mm, 10 mm, 20 mm, 30 mm, 40 mm, 50 mm and 60 mm from the center of the upper surface 14a (see FIG. 12) of the circular seed crystal substrate 14. FIG. 14 is an enlarged cross-sectional view illustrating the apparatus of manufacturing single crystal according to the fourth comparative example. The seven measurement positions are illustrated with arrows in FIG. 14.

In FIG. 13, the graphs at the positions away by 0 mm, 10 mm, 20 mm, 30 mm, 40 mm, 50 mm and 60 mm from the center of the upper surface 14a are illustrated with the thinner dashed line, the thinner dashed dotted line, the dashed double-dotted line, the thinner solid line, the thicker solid line, the thicker dashed line, and the thicker dashed dotted line, respectively. The temperature gradient at the position away by 0 mm is 0.7 °C/cm, and the temperature gradient at the position away by 60 mm is 0.8 °C/cm. The case of the small temperature gradient as described above reduces the temperature difference which is the driving force for the crystal growth, and thus, the crystal is not grown.

For the phase difference of the evaluation items, in each of the examples and the comparative examples, light with a wavelength of 520 nm is transmitted along the <0001> direction through the entire first main surface of the SiC single crystal substrate obtained by the crystal growth, and the phase difference based on the birefringence due to the photoelasticity is measured. The birefringence is caused by the strain caused by the crystal defect or the residual stress in the crystal. The present inventors have found the average value and the maximum value of the phase differences in the phase difference distribution of the SiC single crystal substrate. For the measurement, the 2-dimensional birefringence measurement system WPA300L produced by Photonic Lattice, Inc., is used.

As comprehensive evaluation of each of the working examples and the comparative examples, an example having an average value of the phase differences equal to or smaller than 10 nm is evaluated as passed (circle (O)). An example having an average value of the phase differences equal to or smaller than 10 nm and a maximum value of the phase differences equal to or smaller than 25 nm is evaluated as more desired (double circle (⊚)) among the passed examples.

As illustrated in FIG. 9, in the first to fourth working examples, the in-plane temperature difference is equal to or smaller than 4.0° C, the average value of the phase differences is equal to or smaller than 10 nm, and the maximum value of the phase differences is equal to or smaller than 70 nm. In the third and fourth working examples, the temperature gradient is equal to or larger than 9 °C/cm and equal to or smaller than 25 °C/cm, and the maximum value of the phase differences is equal to or smaller than 40 nm. As described above, the small phase difference can mean the small strain of the object.

### <EFFECTS OF EMBODIMENT>

In the present embodiment, when the thermal strain during the crystal growth is made smaller than thermal strain caused in the sublimation recrystallization method, the SiC single crystal substrate with smaller crystal strain and lower crystal defect density can be obtained. As means for this, in the present embodiment, the SiC single crystal is grown by the solution growth method. The growth temperature can be further lowered in the solution growth method for growing the SiC single crystal from the supercooled liquid phase by dissolving SiC into the metal solvent than in the sublimation recrystallization method. Thus, the thermal strain of the SiC single crystal can be decreased. This manner can solve the room to be improved that is the easiness of the occurrence of the defect in the SiC single crystal grown by the vapor phase growth method.

Further, since the in-plane temperature difference in the contact interface between the lower surface of the seed crystal substrate and the Si-C solution is equal to or smaller than 4.0° C, the SiC single crystal and the SiC single crystal substrate with the average value of the phase differences smaller than 10 nm and the maximum value of the phase differences equal to or smaller than 70 nm can be manufactured. Additionally, since the vertical-directional temperature gradient in the upper surface of the seed crystal substrate is be equal to or larger than 9 °C/cm and equal to or smaller than 25 ° C/cm, the average value of the phase differences and the maximum value of the phase differences can be decreased. The maximum value of the phase differences in the first working example is equal to or smaller than 70 nm. However, this is more preferably equal to or smaller than 50 nm, and much more preferably equal to or smaller than 25 nm as similar to those of the third and fourth working examples.

However, it is conceivable that the uniformed temperature distribution to decrease the in-plane temperature difference in the contact interface between the lower surface of the seed crystal substrate and the Si-C solution to be equal to or smaller than 4.0°C decreases the vertical-directional temperature gradient in the upper surface of the seed crystal substrate to be smaller than 1 °C/cm, thereby decreasing the temperature difference that is the driving force for the crystal growth. In the third and fourth comparative examples, the temperature gradient is extremely small, and consequently the SiC single crystal cannot be obtained, and the phase difference cannot be measured and evaluated to be neither passed nor failed.

To the contrary, in the first to fourth working examples of the present embodiment, the in-plane temperature difference in the contact interface between the lower surface of the seed crystal substrate 14 and the Si-C solution 20 is equal to or smaller than 4.0°C, and the vertical-directional temperature gradient in the upper surface of the seed crystal substrate 14 that is the driving force for the crystal growth is larger than those in the third and fourth comparative examples. In the present embodiment, the heat insulating member 10b is used as the member for keeping the temperature difference in the upper surface of the seed crystal substrate 14 to be equal to or smaller than 4.0°C. The heat insulating member 10a is used as the member for keeping the vertical-directional temperature distribution in the upper surface of the seed crystal substrate 14 to be equal to or larger than 9 °C/cm and equal to or smaller than 25 °C/cm. That is, in the present embodiment, the heat insulating member is arranged at least at a part of the positions away upward from the upper surface of the seed crystal substrate 14. In this case, the above temperature is achieved by arranging the heat insulating members 10a and 10b in the cylinder of the seed crystal holding shaft 16 by use of the seed crystal holding shaft 16 with the inner diameter equal to or larger than that of the seed crystal substrate 14. The heat insulating member 10b is arranged at least at part of the side surface of the seed crystal holding shaft 16 in order to insulate the heat on the side surface of the seed crystal holding shaft 16. As the heat insulating member, the heat insulating member 10a is arranged to cover at least part of the upper surface of the seed crystal substrate 14.

Heat radiation in the vertical direction in the upper surface of the seed crystal substrate 14 is suppressed by the arrangement of the heat insulating members 10a and 10b, thereby unifying the temperatures in the upper surface of the seed crystal substrate 14. The thicker the heat insulating members 10a and 10b are, the more significant the heat insulating effect of the heat insulating members 10a and 10b is. The closer to the upper surface of the seed crystal substrate 14 the heat insulating members 10a and 10b are, the more significant the heat insulating effect of the heat insulating members 10a and 10b is.

Consequently, the temperature distribution in the upper surface of the seed crystal substrate 14 can be unified. However, if the heat insulating members 10a and 10b are too thick or are too close to the upper surface of the seed crystal substrate 14, the vertical-directional heat radiation amount in the upper surface of the seed crystal substrate 14 is decreased. Thus, the temperature difference (temperature gradient) that is the driving force for the crystal growth is decreased. If the heat insulating members 10a and 10b are too far away from the upper surface of the seed crystal substrate 14, the effect of the unified temperature distribution in the upper surface of the seed crystal substrate 14 is decreased. When the molded heat insulating material is used for the heat insulating member 10a, the thickness of the heat insulating member 10a capable of achieving the temperature difference that is the driving force for the crystal growth along with the achievement of the uniformed in-plane temperature distribution in the contact interface between the seed crystal substrate 14 and the Si-C solution 20 is preferably equal to or larger than 3 mm and equal to or smaller than 25 mm, more preferably equal to or larger than 5 mm and equal to or smaller than 15 mm. The arranged position of the heat insulating member 10a to be away from the upper surface of the seed crystal substrate 14 is preferably equal to or larger than 3 mm and equal to or smaller than 50 mm therefrom, more preferably equal to or larger than 10 mm and equal to or smaller than 30 mm therefrom.

If the heat insulating member 10a is difficult to be directly attached to the seed crystal substrate 14, the heat insulating member 10a may be arranged inside a graphite-made hollow jig, and the seed crystal substrate 14 may be attached to the hollow jig.

From the above, the formation of the thermal strain during the crystal growth can be suppressed, and the high-quality SiC single crystal with low crystal defect density can be achieved. The SiC single crystal substrate can be used as a substrate for forming an epitaxial layer for device formation on the first main surface or the second main surface. The number of the SiC single crystal substrates according to the present embodiment to be prepared may be "n", and a set of wafers ("n" is, for example, equal to or larger than 12, preferably equal to or larger than 100) may be made of the "n" SiC single crystal substrates.

In the foregoing, the invention made by the inventors of the present application has been concretely described based on the embodiments. However, it is needless to say that the present invention is not limited to the foregoing embodiments, and various modifications can be made within the scope of the present invention.

Modification example of the embodiments will be described below.

### <FIRST MODIFICATION EXAMPLE>

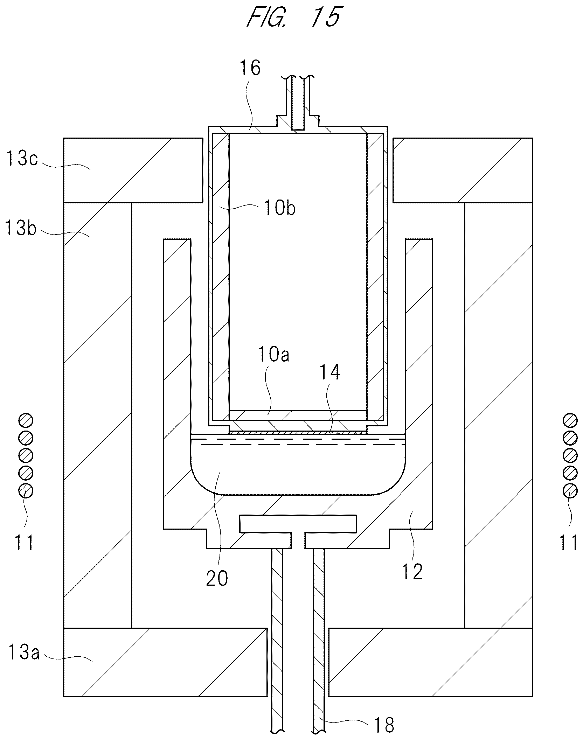

FIG. 15 is a cross-sectional view illustrating an apparatus of manufacturing single crystal according to a first modification example.

In the apparatus of manufacturing single crystal illustrated in FIG. 1, the heat insulating members 10a and 10b are not in contact with each other. To the contrary, in the first modification example illustrated in FIG. 15, the heat insulating members 10a and 10b are in contact with each other. For example, the heat insulating members 10a and 10b may be unified with each other. As described above, the technical idea of the present disclosure is applicable, regardless of the contact between the heat insulating members 10a and 10b.

### <SECOND MODIFICATION EXAMPLE>

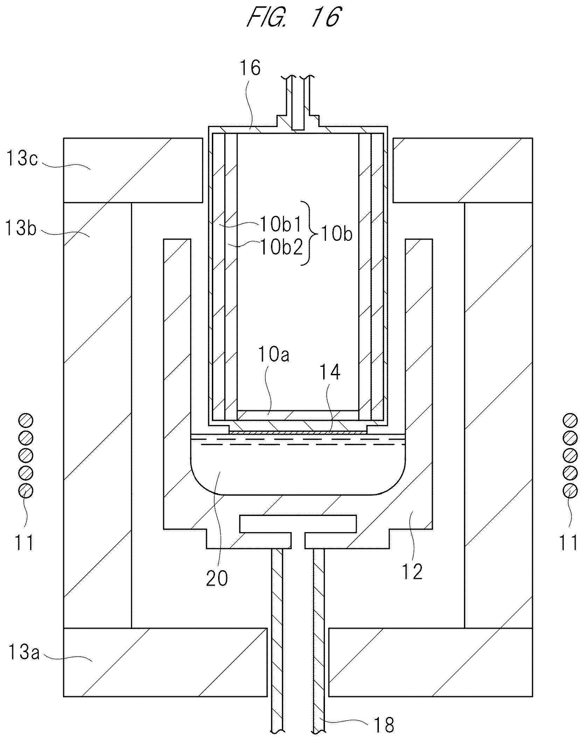

FIG. 16 is a cross-sectional view illustrating an apparatus of manufacturing single crystal according to a second modification example.

In the second modification example, the heat insulating member 10b is made of a heat insulating member 10b1 and a heat insulating member 10b2. The heat insulating member 10b2 is arranged in the heat insulating member 10b1. The heat insulating member 10b2 is in contact with the heat insulating member 10b1. The heat insulating member 10b2 is in contact with the heat insulating member 10a.

The heat insulating members 10b1 and 10b2 may be made of the same material as each other. The heat insulating members 10b1 and 10b2 may be made of the different material from each other. If the heat insulating members 10b1 and 10b2 are made of the different material from each other, for example, combination of the molded heat insulating member and the felt heat insulating member or the like can be exemplified. If the heat insulating members 10b1 and 10b2 are made of the different material from each other, for example, combination of the heat insulating members having different density from each other may be also used.

### <THIRD MODIFICATION EXAMPLE>

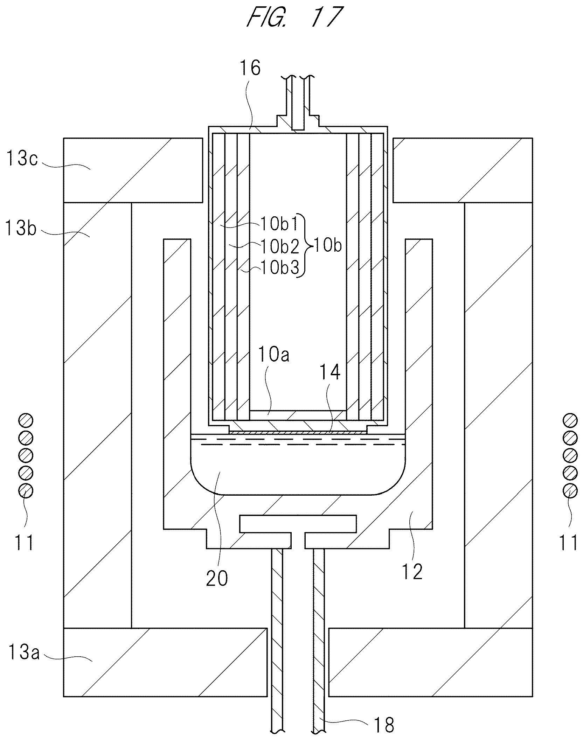

FIG. 17 is a cross-sectional view illustrating an apparatus of manufacturing single crystal according to a third modification example.

In the third modification example, the heat insulating member 10b is made of a heat insulating member 10b1, a heat insulating member 10b2 and a heat insulating member 10b3. The heat insulating member 10b2 is arranged in the heat insulating member 10b1. The heat insulating member 10b3 is arranged in the heat insulating member 10b2. The heat insulating member 10b2 is in contact with the heat insulating member 10b1. The heat insulating member 10b2 is in contact with the heat insulating member 10b3. The heat insulating member 10b3 is in contact with the heat insulating member 10a.

The heat insulating members 10b1, 10b2 and 10b3 may be made of the same material as one another. The heat insulating members 10b1, 10b2 and 10b3 may be made of the different material from one another. If the heat insulating members 10b1, 10b2 and 10b3 are made of the different material from one another, for example, combination of the molded heat insulating member and the felt heat insulating member or the like can be exemplified. If the heat insulating members 10b1, 10b2 and 10b3 are made of the different material from one another, for example, combination of the heat insulating members having different density from one another may be also used.

### <FOURTH MODIFICATION EXAMPLE>

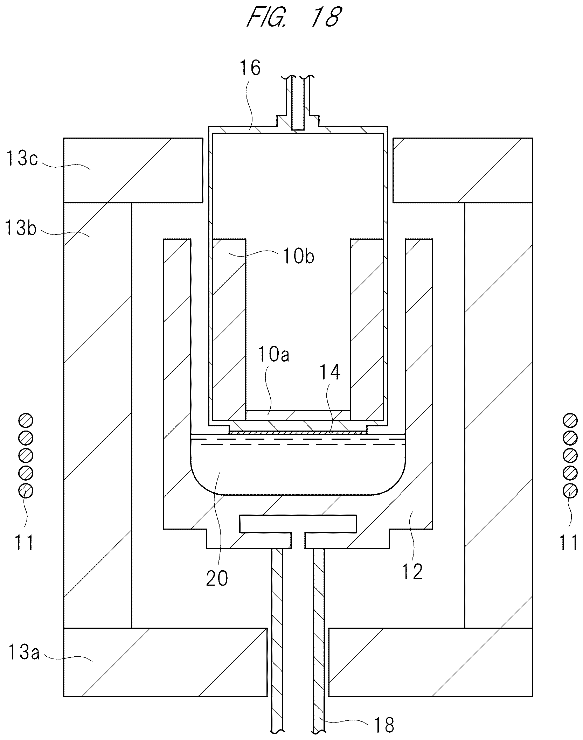

FIG. 18 is a cross-sectional view illustrating an apparatus of manufacturing single crystal according to a fourth modification example.

A cross-sectional shape of the heat insulating member 10b according to the fourth modification example may be different from a cross-sectional shape of the heat insulating member 10b illustrated in FIG. 1. For example, as illustrated in FIG. 18, in the cross-sectional shape of the heat insulating member 10b according to the fourth modification, a radial (lateral) thickness of the seed crystal holding shaft 16 is larger than a thickness of the heat insulating member 10b illustrated in FIG. 1. To the contrary, in the cross-sectional shape of the heat insulating member 10b according to the fourth modification, a lengthwise (longitudinal) length of the seed crystal holding shaft 16 is smaller than a length of the heat insulating member 10b illustrated in FIG. 1. The heat insulating member 10b according to the fourth modification example is in contact with the heat insulating member 10a. In the cross-sectional shape of the heat insulating member 10b according to the fourth modification, in order to achieve the technical idea of the present disclosure, the position of the upper surface of the heat insulating member 10b is desirably equal to or higher than the position of the upper surface of the crucible 12. For example, in the cross-sectional shape of the heat insulating member 10b according to the fourth modification, FIG. 18 illustrates an example in which the position of the upper surface of the heat insulating member 10b is equal to the position of the upper surface of the crucible 12.

## Claims

1. An SiC single crystal substrate including a first main surface and a second main surface opposite to the first main surface,
wherein the first main surface is a surface that tilts relative to a {0001} plane at an off-cut angle equal to or larger than 0° and equal to or smaller than 8°,
in a distribution of phase differences obtained by measuring a phase difference between a first emission light and a second emission light emitted from the second main surface by making an incident light with two mutually perpendicular polarization components and a wavelength of 520 nm into the first main surface,
an average value of the phase differences is equal to or smaller than 10 nm, and
the maximum value of the phase differences is equal to or smaller than 70 nm.

2. The SiC single crystal substrate according to claim 1,
wherein the maximum value of the phase differences is equal to or smaller than 50 nm.

3. The SiC single crystal substrate according to claim 1,
wherein the maximum value of the phase differences is equal to or smaller than 25 nm.

4. The SiC single crystal substrate according to claim 1,
wherein the maximum diameter of the first main surface is equal to or larger than 140 mm.

5. The SiC single crystal substrate according to claim 1,
wherein an epitaxial layer for device formation is provided on the first main surface or the second main surface.

6. The SiC single crystal substrate according to claim 1,
wherein the SiC single crystal substrates, the number of which is "n" ("n" is equal to or larger than 12), configure a set of wafers.

7. A method of manufacturing an SiC single crystal, comprising:
a step (a) of growing the SiC single crystal by bringing a lower surface of a seed crystal substrate into contact with a solution containing silicon (Si) and carbon (C),
wherein in the step (a), the SiC single crystal is grown under a condition that an in-plane temperature difference in a contact interface between the lower surface of the seed crystal substrate and the solution is equal to or smaller than 4.0°C while a temperature gradient upward from an upper surface opposite to the lower surface of the seed crystal substrate is equal to or larger than 9 °C/cm and equal to or smaller than 25 °C/cm.

8. An apparatus of manufacturing SiC single crystal comprising:
a seed crystal holding shaft including a cylinder and enabling a seed crystal substrate to be held under the cylinder;
a side-surface heat insulating member provided in the cylinder; and
an upper-surface heat insulating member provided in the cylinder,
wherein the seed crystal substrate has a lower surface enabled to be in contact with a solution housed in a crucible and an upper surface opposite to the lower surface,
the solution contains silicon (Si) and carbon (C),
an inner diameter of the cylinder is equal to or larger than a diameter of the seed crystal substrate,
the side-surface heat insulating member has such a length that a part of the side-surface heat insulating member is enabled to be upper than an upper end of the crucible when the lower surface of the seed crystal substrate is brought into contact with the solution, and
the upper-surface heat insulating member is away upward from the upper surface of the seed crystal substrate.

9. The apparatus of manufacturing SiC single crystal according to claim 8,
wherein the side-surface heat insulating member is a member having an in-plane temperature difference in a contact interface between the lower surface of the seed crystal substrate and the solution to be equal to or smaller than 4.0°C, and
the upper-surface heat insulating member is a member having a temperature distribution in an upward direction from the upper surface of the seed crystal substrate to be equal to or larger than 9 °C/cm and equal to or smaller than 25 ° C/cm.

10. The apparatus of manufacturing SiC single crystal according to claim 8,
wherein the side-surface heat insulating member is in contact with the upper-surface heat insulating member.

11. The apparatus of manufacturing SiC single crystal according to claim 8,
wherein the side-surface heat insulating member is not in contact with the upper-surface heat insulating member.

12. The apparatus of manufacturing SiC single crystal according to claim 8,
wherein the side-surface heat insulating member includes:
a first side-surface heat insulating member; and
a second side-surface heat insulating member being in contact with the first side-surface heat insulating member.

13. The apparatus of manufacturing SiC single crystal according to claim 12,
wherein the side-surface heat insulating member further includes:
a third side-surface heat insulating member being in contact with the second side-surface heat insulating member.

14. The apparatus of manufacturing SiC single crystal according to claim 8,
wherein in a cross-sectional view, a position of an upper surface of the side-surface heat insulating member is equal to or upper than a position of an upper surface of the crucible.

15. The apparatus of manufacturing SiC single crystal according to claim 14,
wherein in a cross-sectional view, the position of the upper surface of the side-surface heat insulating member is equal to the position of the upper surface of the crucible.
